# EUROPEAN PATENT SPECIFICATION

(11) **EP 3 345 231 B1**
(45) Date of publication and mention of the grant of the patent: **03.05.2023**
(21) Application number: 16770594.6
(22) Date of filing: 30.08.2016
(51) Int. Cl.: H01L 51/52, B32B 17/06, H01L 23/10, C09K 11/08, C03C 27/08, C04B 37/04

(54) **DEVICES COMPRISING TRANSPARENT SEALS AND METHODS FOR MAKING THE SAME**
VORRICHTUNGEN MIT TRANSPARENTEN DICHTUNGEN UND VERFAHREN ZUR HERSTELLUNG DAVON
DISPOSITIFS COMPRENANT DES JOINTS D'ÉTANCHÉITÉ TRANSPARENTS, ET LEURS PROCÉDÉS DE FABRICATION

(30) Priority: 04.09.2015 US 201562214275 P
(43) Date of publication of application: 11.07.2018
(73) Proprietor: Corning Incorporated, Corning, New York 14831 (US)
(72) Inventor: DEJNEKA, Matthew John, Corning, New York 14830 (US); DUTTA, Indrajit, Horseheads, New York 14845 (US); KOVAL, Shari Elizabeth, Beaver Dams, New York 14812 (US); LOGUNOV, Stephan Lvovich, Corning, New York 14830 (US); QUESADA, Mark Alejandro, Horseheads, New York 14845 (US)
(74) Representative: Elkington and Fife LLP
(86) International application number: PCT/US2016/049405
(87) International publication number: WO 2017/040475

(56) References cited:
- WO-A1-2008/085226
- WO-A1-2014/182776
- WO-A1-2015/114291
- CN-A- 103 035 849

## Description

### FIELD OF THE DISCLOSURE

The disclosure relates generally to sealed devices and more particularly to transparent hermetic seals comprising metal nanoparticles as well as methods for making such seals using metal films.

### BACKGROUND

Sealed glass packages and casings are increasingly popular for application to electronics and other devices that may benefit from a hermetic environment for sustained operation. Exemplary devices which may benefit from hermetic packaging include televisions, sensors, optical devices, organic light emitting diode (OLED) displays, 3D inkjet printers, laser printers, solid-state lighting sources, and photovoltaic structures. For instance, displays comprising OLEDs or quantum dots (QDs) may call for sealed hermetic packages to prevent the possible decomposition of these materials at atmospheric conditions.

Glass, ceramic, and glass-ceramic substrates can be sealed by placing the substrates in a furnace, with or without an epoxy or other sealing material. However, the furnace typically operates at high processing temperatures which are unsuitable for many devices, such as OLEDs and QDs. These substrates can also be sealed using glass frit, e.g., by placing glass frit between the substrates and heating the frit with a laser or other heat source to seal the package. Frit-based sealants can include, for instance, glass materials ground to an average particle size ranging typically from about 2 to 150 microns. The glass frit material can be mixed with a negative CTE material having a similar particle size to lower the mismatch of thermal expansion coefficients between substrates and the glass frit.

However, glass frit may require higher processing temperatures unsuitable for devices such as OLEDs or QDs and/or may produce undesirable gases upon sealing. Frit seals may also have undesirably low tensile strength and/or shear strain. Additionally, the use of these materials to form hermetic seals can result in an opaque seal due to the negative CTE inorganic fillers in the frit paste.

Transparent seals are desirable in a variety of applications, such as display applications. For example, transparent seals may reduce the amount of display area that might otherwise be covered with a bezel for aesthetic purposes. Accordingly, it would be advantageous to provide sealed devices which are both transparent and hermetic, as well as methods for forming such devices.
WO 2015/114291 A1 relates to a method of welding together glass workpieces where one of the workpieces has metal nanoparticles positioned at or near the surface to be welded. CN 103035849 A is directed to a packaging structure including two base plates with a sealed space that seals a display zone. WO 2014/182776 A1 relates to a method of sealing a workpiece comprising forming an inorganic film over a surface of a first substrate. WO 2008/085226 A1 is directed to a method of sealing glass articles between two sealing surfaces.

### SUMMARY

The disclosure relates to a sealed device as recited in claim 1. A seal thus formed can, in some embodiments, be hermetic and/or transparent.

The disclosure also relates to a method for making a sealed devicce as recited in claim 8.

Additional features and advantages of the disclosure will be set forth in the detailed description which follows, and in part will be readily apparent to those skilled in the art from that description or recognized by practicing the methods as described herein, including the detailed description which follows, the claims, as well as the appended drawings.

It is to be understood that both the foregoing general description and the following detailed description present various embodiments of the disclosure, and are intended to provide an overview or framework for understanding the nature and character of the claims. The accompanying drawings are included to provide a further understanding of the disclosure, and are incorporated into and constitute a part of this specification. The drawings illustrate various embodiments of the disclosure and together with the description serve to explain the principles and operations of the disclosure.

### BRIEF DESCRIPTION OF THE DRAWINGS

The following detailed description can be further understood when read in conjunction with the following drawings.
**FIG. 1** illustrates a side view of an unsealed device comprising a sealing layer according to various embodiments of the disclosure;
**FIG. 2** is a plot illustrating the reflectivity of certain metals as a function of wavelength;
**FIG. 3** illustrates a top view of the unsealed device of **FIG. 1**;
**FIG. 4A** is a transmission electron microscopy (TEM) image of an exemplary glass-metal-glass interface prior to sealing;
**FIG. 4B** is a TEM image of an exemplary seal comprising metal nanoparticles between two glass substrates;
**FIG. 5** illustrates a top view of a sealed device according to various embodiments of the disclosure; and
**FIG. 6** illustrates cross-sectional view of the sealed device of **FIG. 5** taken through line **A-A**.

### DETAILED DESCRIPTION

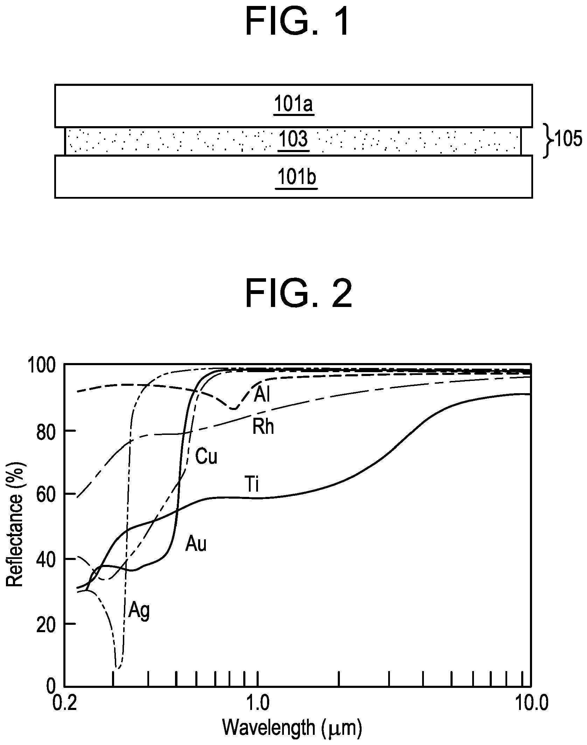

Various embodiments of the disclosure will now be discussed with reference to **FIGS. 1-6**, which illustrate exemplary methods and devices. The following general description is intended to provide an overview of the claimed methods and devices, and various aspects will be more specifically discussed throughout the disclosure with reference to the non-limiting embodiments, these embodiments being interchangeable with one another within the context of the disclosure.

### Methods

Disclosed herein are methods for making sealed devices comprising positioning a sealing layer comprising at least one metal between a first glass substrate and a second substrate to form a sealing interface; and directing a laser beam operating at a predetermined wavelength onto the sealing interface to form at least one seal between the first and second substrates and to convert the at least one metal to metal nanoparticles having an average particle size of less than about 50 nm. The at least one seal can, in some embodiments, be transparent at visible wavelengths and/or hermetic.

As shown in **FIG. 1**, first and a second substrates **101a, 101b** and a sealing layer **103** comprising at least one metal, are brought into contact to form a sealing interface **105**. The sealing interface, as referred to herein, is the point of contact between the first glass substrate **101a**, the second substrate **101b**, and the sealing layer **103**, e.g., the meeting of the surfaces to be joined by the weld or seal. The substrates and sealing layer may be brought into contact by any means known in the art and may, in certain embodiments, be brought into contact using force, e.g., an applied compressive force. For instance, the sealing layer can be applied to either the first or second substrate or, in some embodiments, to both the first and second substrates. By way of a non-limiting example, the substrates may be arranged between two plates and pressed together. In certain embodiments, clamps, brackets, vacuum chucks, and/or other fixtures may be used to apply a compressive force so as to ensure good contact at the sealing interface.

The first and/or second substrates **101a, 101b** may, in some embodiments, comprise any glass known in the art, including, but not limited to, soda-lime silicate, aluminosilicate, alkali-aluminosilicate, borosilicate, alkali-borosilicate, aluminoborosilicate, alkali-aluminoborosilicate, fused silica, and other suitable glasses. These substrates may, in various embodiments, be chemically strengthened and/or thermally tempered. Non-limiting examples of suitable commercially available substrates include EAGLE XG^{®}, Iris^{™}, Lotus^{™}, Willow^{®}, and Gorilla^{®} glasses from Corning Incorporated, to name a few. Glasses that have been chemically strengthened by ion exchange may be suitable as substrates according to some non-limiting embodiments. In certain embodiments, the first and second substrates may be chosen from identical or different glasses.

Suitable glass substrates can, for example, have a glass transition temperature (T_{g}) of less than about 1000°C, such as less than about 950°C, less than about 900°C, less than about 850°C, less than about 800°C, less than about 750°C, less than about 700°C, less than about 600°C, less than about 500°C, less than about 450°C, or less, such as ranging from about 450°C to about 1000°C, including all ranges and subranges therebetween. In additional embodiments, the first and/or second substrates **101a, 101b** can have a T_{g} greater than 1000°C, such as greater than about 1100°C, greater than about 1200°C, greater than about 1250°C, greater than about 1300°C, or more, such as ranging from about 1000°C to about 1300°C, including all ranges and subranges therebetween. In certain embodiments, the first and second substrates may have identical or different T_{g}.

According to various embodiments, the first and/or second substrates **101a, 101b** may be chosen from glasses having a compressive stress greater than about 100 MPa and a depth of layer of compressive stress (DOL) greater than about 10 microns. In further embodiments, the first and/or second substrates **101a, 101b** may have a compressive stress greater than about 500 MPa and a DOL greater than about 20 microns, or a compressive stress greater than about 700 MPa and a DOL greater than about 40 microns. In alternative embodiments, the second substrate **101b** may comprise a material other than glass, such as a ceramic or glass-ceramic. Exemplary suitable materials from which the second substrate may be constructed include, without limitation, aluminum nitride, aluminum oxide, beryllium oxide, boron nitride, and silicon carbide, to name a few.

In non-limiting embodiments, the first and/or second substrates **101a, 101b** can have a thickness of less than or equal to about 3 mm, for example, ranging from about 0.1 mm to about 2 mm, from about 0.2 mm to about 1.5 mm, from about 0.3 mm to about 1.2 mm, from about 0.4 mm to about 1 mm, from about 0.5 mm to about 0.8 mm, or from about 0.6 mm to about 0.7 mm, including all ranges and subranges therebetween. According to various embodiments, the first and/or second substrates **101a, 101b** can have a thickness greater than 3 mm, such as greater than 4 mm, greater than 5 mm, or more, including all ranges and subranges therebetween.

The first and/or second substrates **101a, 101b** can, in various embodiments, be transparent or substantially transparent. As used herein, the term "transparent" is intended to denote that the glass substrate has a transmission of greater than about 90% at a given wavelength. For instance, an exemplary transparent glass substrate may have greater than about 90% transmittance in the visible light range (420-700nm), such as greater than about 92%, greater than about 94%, greater than about 96% or greater than about 98%, such as ranging from about 90% to about 98%, including all ranges and subranges therebetween.

The first and/or second substrates **101a, 101b** can also be transparent or substantially transparent at the laser's operating wavelength (e.g., an absorption of less than about 10% or a transmission greater than about 90%). For instance, the first and/or second substrates **101a, 101b** can absorb less than about 8%, less than about 6%, less than about 4%, less than about 2%, and less than about 1%, such as from about 1% to about 10% of the laser's operating wavelength, including all ranges and subranges therebetween. For example, an exemplary glass substrate may absorb less than about 10% of light at ultraviolet (UV) wavelengths (<420 nm) and infrared (IR) wavelengths (>700 nm).

According to the invention, the sealing layer comprises at least one metal. For example, the sealing layer can comprise at least one metal chosen from aluminum, iron, copper, silver, gold, chromium, titanium, rhodium, magnesium, nickel, zinc, molybdenum, alloys thereof (such as aluminum alloys, magnesium alloys, steel, stainless steel, or brass, to name a few), and combinations thereof. According to the invention, the sealing layer comprises at least one metal, for example, the sealing layer can be chosen from aluminum, stainless steel, copper, silver, and gold films, and the like. In some embodiments, the sealing layer can be free or substantially free of metal particles that may have absorption peaks in the visible spectrum due to plasmonic resonances, e.g., gold or copper and the like.

According to certain embodiments, the sealing layer can comprise two or more films, each film comprising at least one metal. For example, a combination of an aluminum film and a silver film may be used, or any other combination of metal films disclosed above. In other embodiments, the sealing layer may comprise a single film comprising a mixture of metals, e.g., chromium and titanium, or any other combination of metals disclosed above. By way of a non-limiting example, the sealing layer can have a thickness of less than about 500 nm, such as less than about 400 nm, less than about 300 nm, less than about 200 nm, less than about 100 nm, less than about 50 nm, less than about 25 nm, or less than about 10 nm, such as ranging from about 10 nm to about 500 nm, including all ranges and subranges therebetween. Other exemplary embodiments can employ a sealing layer comprising two films each having a thickness of 500 nm or less, such as 250 nm or less, or 100 nm or less, e.g., ranging from about 10 nm to about 500 nm, including all ranges and subranges therebetween.

In other non-limiting embodiments, the sealing layer can comprise at least one metal film and at least one glass sealing film. The glass sealing film can be chosen, for example, from glass compositions having an absorption of greater than about 10% at the predetermined laser operating wavelength and/or a relatively low glass transition temperature According to various embodiments, the glass sealing film can be chosen from borate glasses, phosphate glasses tellurite glasses, and chalcogenide glasses, for instance, tin phosphates, tin fluorophosphates, and tin fluoroborates.

In general, suitable sealing glasses can include low T_{g} glasses and suitably reactive oxides of copper or tin. By way of non-limiting example, the sealing layer can comprise a glass with a T_{g} of less than or equal to about 400°C, such as less than or equal to about 350°C, about 300°C, about 250°C, or about 200°C, including all ranges and subranges therebetween, such as ranging from about 200°C to about 400°C. Suitable glass sealing films and methods are disclosed, for instance, in U.S. Patent Application Nos. 13/777,584; 13/891,291; 14/270,828; and 14/271,797.

In some embodiments, the thickness of the sealing layer and/or the one or more films can be chosen to obtain a desired combination of sealing and optical properties. For instance, the sealing layer thickness may be chosen such that a portion of the sealing layer is converted into metal nanoparticles, thereby forming a seal between the two substrates, whereas another portion of the sealing layer remains intact, thereby providing scattering and/or reflective properties to the seal. According to additional embodiments, two or more films may be used, each having a thickness chosen to produce a desired combination of sealing and optical properties. For example, the total sealing layer thickness may be greater than or less than 500 nm, or the thickness of one or more films making up the sealing layer may be, alone or in combination, greater than or less than 500 nm.

In certain non-limiting embodiments, the sealing layer **103** can have an absorption of greater than about 10% at the laser's operating wavelength. For instance, the sealing layer **103** can have an absorption greater than about 20% at the laser's operating wavelength, such as greater than about 30%, greater than about 40%, greater than about 50%, greater than about 60%, greater than about 70%, greater than about 80%, or greater than about 90%, such as ranging from about 10% to about 90%, including all ranges and subranges therebetween. In certain embodiments, the sealing layer **103** can absorb greater than about 10% of light at UV (< 420nm), visible (420-700nm), and infrared (>700 nm) wavelengths). As shown in **FIG. 2**, various metals can absorb (e.g., greater than about 10% absorption) light at UV and visible wavelengths, and some can also absorb at IR wavelengths.

In certain embodiments, the sealing layer **103** can have a melting point of less than about 1000°C, such as less than about 950°C, less than about 900°C, less than about 850°C, less than about 800°C, less than about 750°C, less than about 700°C, less than about 600°C, less than about 500°C, or less, such as ranging from about 500°C to about 1000°C, including all ranges and subranges therebetween. In additional embodiments, the sealing layer **103** can have a melting point greater than 1000°C, such as greater than about 1100°C, greater than about 1200°C, greater than about 1300°C, greater than about 1400°C, greater than about 1500°C, greater than about 1600°C, greater than about 1700°C, greater than about 1800°C, greater than about 1900°C, or greater than about 2000°C, such as ranging from about 1000°C to about 2000°C, including all ranges and subranges therebetween. In some embodiments, the sealing layer can comprise a metal and the melting point of the sealing layer can be approximately equal to the melting point of the metal.

Without wishing to be bound by theory, it is believed that absorption of laser radiation by the sealing layer can generate heat at the sealing interface. For example, the sealing interface may be locally heated to a sealing temperature at which the at least one metal is converted to metal nanoparticles and the first and/or second substrates are softened or melted to form a seal. The sealing temperature can be, in some embodiments, greater than the melting point of the at least one metal and/or the T_{g} of the first and/or second substrates. For instance, the sealing temperature can be less than about 1000°C, such as less than about 950°C, less than about 900°C, less than about 850°C, less than about 800°C, less than about 750°C, less than about 700°C, less than about 600°C, less than about 500°C, or less, such as ranging from about 500°C to about 1000°C, including all ranges and subranges therebetween. In additional embodiments, the sealing temperature can be greater than 1000°C, such as greater than about 1100°C, greater than about 1200°C, greater than about 1300°C, greater than about 1400°C, greater than about 1500°C, greater than about 1600°C, such as ranging from about 1000°C to about 1700°C, including all ranges and subranges therebetween.

According to various embodiments, the sealing layer **103** comprising at least one metal may be non-transparent, e.g., at visible wavelengths. In additional embodiments, after laser exposure, the sealing layer 103 can be transformed into substantially transparent metal nanoparticles. According to the invention, the metal nanoparticles are incorporated into the surface(s) of the first and/or second substrates, thus forming part of the seal, e.g., a film or layer of metal nanoparticles and glass. The metal nanoparticles may, in various embodiments, be dispersed in the glass, e.g., the particles are mixed with, but not part of or otherwise dissolved in, the glass.

During the conversion process, the metal nanoparticles can, in certain embodiments, be partially or completely dissolved in one or more of the first or second substrates. Without wishing to be bound by theory, a mechanism for converting the sealing layer to metal nanoparticles may involve dissolution of the metal into the glass at elevated temperatures, followed by precipitation of the metal when the glass cools. Furthermore, solubility of the metals in the glass may affect the degree to which the metal nanoparticles can travel or be distributed in the glass (e.g., the thickness of the resulting seal). In some instances, it is possible that the metal may be oxidized, either by atmospheric oxygen or by multivalents in the glass to facilitate dissolution of the metal into the glass. For example, in the case of an iron film, which is not highly soluble in glass (as elemental Fe), iron oxide (FeO) may be formed by atmospheric oxidation according to formula (1) or by reaction with a multivalent glass component according to formula (2):

2Fe (film) + O₂ (air) → FeO (glass) (1)

SnO₂ (glass) + Fe (film) → SnO (glass) + FeO (glass) (2)

Of course these reactions are merely exemplary and are not intended to limit the scope of the claims. Regardless of the proposed mechanism of action, absorption of the laser radiation by the sealing layer may serve to break up the continuity of the film or sealing layer, which can in turn result in a transparent seal comprising relatively small metal nanoparticles (e.g., an average particle size of less than 50 nm or even less than 10 nm).

According to some embodiments, the seal may comprise a layer or region of the first and/or second substrates in which the metal nanoparticles are dispersed or incorporated. In additional embodiments, the layer may have a thickness ranging from about 100 nm to about 500 microns, such as from about 150 nm to about 250 microns, from about 200 nm to about 100 microns, from about 300 nm to about 50 microns, from about 400 nm to about 25 microns, or from about 500 nm to about 10 microns, including all ranges and subranges therebetween.

It is to be understood that transforming the at least one metal into metal nanoparticles which are then incorporated into the glass substrate(s) is distinct from diffusing a metal plasma into the glass. Diffusion can be carried out by vaporizing the metal, e.g., by forming a plasma, and then diffusing the gaseous metal into the glass. In contrast, metal nanoparticles are solid particles that can be incorporated into the glass. Due to the low absorption cross-section of the metal nanoparticles, the nanoparticles (as well as the seal) can be transparent, e.g., at visible wavelengths. As such, in various embodiments, the sealing temperature may be below the sublimation temperature of the at least one metal and/or sealing layer. According to additional embodiments, the sealing temperature is below the temperature at which a plasma comprising the at least one metal is formed.

It is also to be understood that transforming the at least one metal into metal nanoparticles which are then incorporated into the glass substrate(s) is distinct from using a sealing layer comprising metal oxides (e.g., low-melting glass "LMG" compositions comprising ZnO, SnO, SnO₂, and/or P₂O₅, and the like). For instance, while such metal oxides may have high solubility in the glass and therefore can be widely distributed throughout the sealing region or interface (e.g., traveling up to several microns deep from the substrate surface), the metal nanoparticles disclosed herein have relatively lower solubility and thus may travel much shorter distances, such as less than about 100 nm, e.g., less than about 90, 80, 70, 60, 50, 40, 30, 20, or 10 nm, including all ranges and subranges therebetween. In some embodiments, the metal nanoparticles may be converted to metal oxides, e.g., by reacting with atmospheric oxygen or multivalent components in the glass. However, even so, the distribution of such a converted metal oxide may be far less than that of a metal oxide originally incorporated into the sealing layer, and the metal oxide thus formed may be precipitated as a metal nanoparticle upon cooling of the glass.

Without wishing to be bound by theory, it is believed that substantially simultaneous melting of the glass substrates and sealing layer can produce metal nanoparticles which can be incorporated into the softened glass to form a substantially transparent seal. Accordingly, in some embodiments, the sealing layer **103** and first and second substrates **101a, 101b** may be chosen such that the melting point of the sealing layer is substantially similar to the T_{g} of at least about 400°C, 300°C, 200°C, 100°C, 90°C, 80°C, 70°C, 60°C, 50°C, 40°C, 30°C, 20°C, 10°C, or 5°C, including all ranges and subranges therebetween.

If the melting temperature of the sealing layer **103** is too low relative to the T_{g} of the first and/or second substrates **101a**, **101b**, the sealing layer may melt before one or more of the glass substrates and, thus, the glass substrate(s) will not be softened or melted enough to form a bond. As such, in various embodiments, the melting point of the sealing layer can be greater than 50% of the T_{g} of the first and/or second substrates, such as greater than about 60%, 70%, 80%, 90%, 91%, 92%, 93%, 94%, 95%, 96%, 97%, 98%, or 99%. According to the invention, a melting point of the metal forming the metal nanoparticles is ranging from about 50% to about 100% of the T_{g} of the first and/or second substrates, including all ranges and subranges therebetween. If, on the other hand, the melting temperature of the sealing layer **103** is too high relative to the melting temperature of the first and/or second substrates **101a**, **101b**, the first and/or second substrates **101a, 101b** will melt before the metal nanoparticles are formed and the seal may not be transparent.

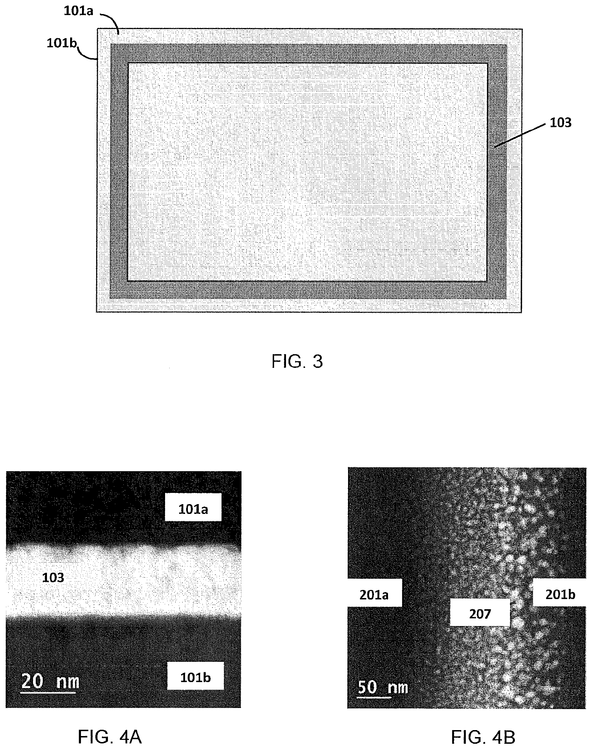

**FIG. 3** is a top view of the unsealed device depicted in **FIG. 1**. As depicted, the first and second substrates **101a, 101b** can be transparent and, thus, are both visible in the depicted embodiment. The sealing layer **103** can be non-transparent according to various embodiments. While the non-limiting embodiment depicted in **FIG. 3** comprises a sealing layer **103** in a rectangular pattern around the edges of the glass substrates, it is to be understood that the sealing layer can have any given pattern, size, shape, and/or location. For example, the sealing layer can cover all or substantially all of a surface of the first and/or second substrate. Such an embodiment may be envisioned in the case of vacuum insulated glass (VIG). Alternatively, the sealing layer can be applied the first and/or second substrate to form any given pattern. For example, a workpiece may be placed between the first and second substrates and the sealing layer may be disposed around the workpiece, e.g., framing the workpiece. Such a frame may extend along a perimeter of the glass substrates, e.g., at the edges of the substrates. Of course, any shape, such as square, rectangular, circular, regular, or irregular patterns, and the like can be used, form any given pattern. For example, a workpiece may be placed between the first and second substrates and the sealing layer may be disposed around the workpiece, e.g., framing the workpiece. Such a frame may extend along a perimeter of the glass substrates, e.g., at the edges of the substrates. Of course, any shape, such as square, rectangular, circular, regular, or irregular patterns, and the like can be used, in any location on the glass substrate, including the peripheral and/or central regions of the substrates.

To seal the device of **FIG. 3**, a laser (not illustrated) can be scanned or translated along the substrates (or the substrates can be translated relative to the laser) using any predetermined path to produce any pattern, such as a square, rectangular, circular, oval, or any other suitable pattern or shape. The laser used to form the seal between the first and second substrates may be chosen from any suitable continuous wave or quasi-continuous wave laser known in the art for glass substrate welding. Exemplary lasers and methods therefor to form seals are described in co-pending U.S. Application Nos. 13/777,584; 13/891,291; 14/270,828; and 14/271,797.

For example, the laser may emit light at UV (< 420 nm), visible (420-700 nm), or IR (> 700 nm) wavelengths. In certain embodiments, a continuous wave or high-repetition quasi-continuous wave laser operating at about 355 nm, or any other suitable UV wavelength, may be used. In other embodiments, a continuous wave or high-repetition quasi-continuous wave laser operating at about 532 nm, or any other suitable visible wavelength, may be used. In further embodiments, a continuous wave or high-repetition quasi-continuous wave laser operating at about 810 nm, or any other suitable IR wavelength, may be used. According to various embodiments, the laser may operate at a predetermined wavelength ranging from about 300 nm to about 1600 nm, such as from about 350 nm to about 1400 nm, from about 400 nm to about 1000 nm, from about 450 nm to about 750 nm, from about 500 nm to about 700 nm, or from about 600 nm to about 650 nm, including all ranges and subranges therebetween.

The translation speed at which the laser beam (or substrate) moves along the interface may vary by application and may depend, for example, upon the composition of the sealing layer and/or the first and second substrates and/or the laser parameters, such as focal configuration, laser power, frequency, and/or wavelength. In certain embodiments, the laser may have a translation speed ranging from about 1 mm/s to about 1000 mm/s, for example, from about 5 mm/s to about 750 mm/s, from about 10 mm/s to about 500 mm/s, or from about 50 mm/s to about 250 mm/s, such as greater than about 100 mm/s, greater than about 200 mm/s, greater than about 300 mm/s, greater than about 400 mm/s, greater than about 500 mm/s, or greater than about 600 mm/s, including all ranges and subranges therebetween.

According to various embodiments, the laser beam can operate at an average power greater than about 3W, for example, ranging from about 6 W to about 15 kW, such as from about 7 W to about 12 kW, from about 8 W to about 11 kW, or from about 9 Wto about 10 kW, including all ranges and subranges therebetween. The laser may operate at any frequency and may, in certain embodiments, operate in a quasi-continuous or continuous manner. In some non-limiting embodiments, the laser may have a frequency or repetition ranging from about 1 kHz to about 5 MHz, such as from about 10 kHz to about 4 MHz, from about 50 kHz to about 3 MHz, from about 100 kHz to about 2 MHz, from about 250 kHz to about 1 MHz, or from about 500 kHz to about 750 kHz, including all ranges and subranges therebetween.

According to various embodiments, the laser beam may be directed at and focused on the sealing interface, below the sealing interface, or above the sealing interface, such that the beam spot diameter on the interface may be less than about 1 mm. For example, the beam spot diameter may be less than about 500 microns, such as less than about 400 microns, less than about 300 microns, or less than about 200 microns, less than about 100 microns, less than 50 microns, or less than 20 microns, including all ranges and subranges therebetween. In some embodiments, the beam spot diameter may range from about 10 microns to about 500 microns, such as from about 50 microns to about 250 microns, from about 75 microns to about 200 microns, or from about 100 microns to about 150 microns, including all ranges and subranges therebetween.

In certain embodiments disclosed herein, the laser wavelength, repetition rate (modulation speed), average power, focusing conditions, and other relevant parameters may be varied so as to produce energy sufficient to weld the first and second substrates together by way of the sealing layer. It is within the ability of one skilled in the art to vary these parameters as necessary for a desired application. In various embodiments, the laser fluence (or intensity) is below the damage threshold of the first and/or second substrate, e.g., the laser operates under conditions intense enough to weld the substrates together, but not so intense as to damage the substrates. In certain embodiments, a quasi-continuous wave laser beam may operate at a translation speed that is less than or equal to the product of the diameter of the laser beam at the sealing interface and the repetition rate of the laser beam. In other embodiments, the translation speed may be greater than the product of the diameter of the laser beam at the sealing interface and the repetition rate of the laser beam.

As a non-limiting example, **FIG. 4A** is a TEM image of two glass substrates **101a**, **101b**, with a sealing layer **103** disposed therebetween prior to sealing. In the illustrated embodiment, the sealing layer **103** is a 25 nm thick stainless steel film. **FIG. 4B** is a TEM image of the sealed device after welding with laser radiation. Glass substrates **201a, 201b** are bonded together by seal **207** comprising metal nanoparticles. The seal **207** has a thickness of about 200 nm and the nanoparticles are about 2 nm or smaller in size.

### Devices

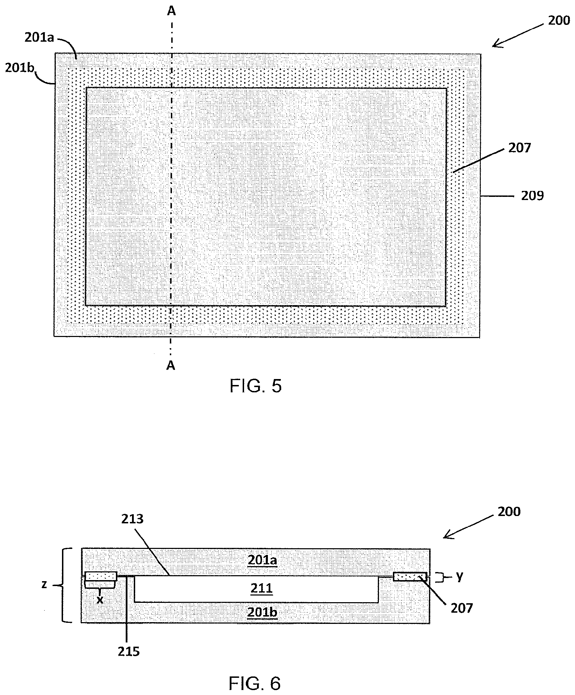

Disclosed herein are sealed devices comprising a first glass substrate, a second substrate, and at least one seal disposed therebetween, wherein the at least one seal comprises metal nanoparticles having an average particle size of less than about 50 nm. As used herein, the term "particle size" and variations thereof is intended to denote the largest dimension of a nanoparticle, such as a diameter, although it is understood that the nanoparticles need not be spherical and can have any other suitable shape, such as ovoid, irregular, and the like. **FIG. 5** illustrates a top view of a sealed device **200** which can be formed according to the methods disclosed herein. **FIG. 6** is a cross-sectional view of the sealed device of **FIG. 5** taken through line **A-A**.

The first and second substrates **201a**, **201b**, are bonded together by at least one seal **207**, which comprises metal nanoparticles (not labeled). Again, while **FIG. 4** depicts the seal **207** as a rectangular frame proximate the edges **209** of the glass substrates, it is to be understood that the seal may have any shape, size, and/or location, as desired for a particular application. Moreover, while the seal **207** is visible in **FIG. 5**, it is to be understood that such visibility is only included for purposes of description and is not intended to be limiting on the appended claims. The seal can, in various embodiments, be transparent or substantially transparent.

Referring to **FIG. 5**, the seal **207** can have any width **x**, for example, ranging from about 50 microns to about 1 mm, such as from about 75 microns to about 500 microns, from about 100 microns to about 300 microns, or from about 125 microns to about 250 microns, including all ranges and subranges therebetween. The seal **207** can likewise have any thickness **y**, such as ranging from about 100 nm to about 500 microns, such as from about 150 nm to about 250 microns, from about 200 nm to about 100 microns, from about 300 nm to about 50 microns, from about 400 nm to about 25 microns, or from about 500 nm to about 10 microns, including all ranges and subranges therebetween.

As discussed above, the seal **207** comprises metal nanoparticles having an average particle size of less than about 50 nm, such as less than about 45 nm, 40 nm, 35 nm, 30 nm, 25 nm, 20 nm, 15 nm, 10 nm, 5 nm, 4 nm, 3 nm, 2 nm, or 1 nm, e.g., ranging from about 1 nm to about 50 nm, including all ranges and subranges therebetween. According to various embodiments, the size and/or concentration of the nanoparticles in the region of the seal are chosen such that the seal **207** is transparent at visible wavelengths. For example, the seal may comprise from about 1 000 to about 100 000 nanoparticles per µm³, such as from about 20 000 to about 90 000 nanoparticles, from about 30 000 to about 80 000 nanoparticles, from about 40 000 to about 70 000 nanoparticles, or from about 50 000 to about 60 000 nanoparticles per µm³, including all ranges and subranges therebetween. Of course, the concentration of metal nanoparticles may be greater in the case of a non-transparent seal. The concentration of the nanoparticles in the seal **207** can vary, in some embodiments, as a function of the thickness of the sealing layer **103** and/or the particle size of the nanoparticles produced from the sealing layer during laser radiation.

The first and second substrates **201a, 201b** can be chosen from the same materials and can have the same properties discussed above with respect to substrates **101a**, **101b**. The first glass substrate **201a** can comprise a first surface **213** and the second substrate **201b** can comprise a second surface **215**, these surfaces being bonded together by seal **207**. The first and second surfaces **213**, **215** may, in various embodiments, be parallel or substantially parallel. The substrates can comprise at least one edge **209**, for instance, at least two edges, at least three edges, or at least four edges, and the substrates can be sealed at the edges. By way of a non-limiting example, the first and/or second substrates **201a, 201b** may comprise a rectangular or square glass (or glass-ceramic or ceramic) sheet having four edges, although other shapes and configurations are envisioned and are intended to fall within the scope of the disclosure. According to certain embodiments, the total thickness z of the sealed device **200** can be less than about 5 mm, such as less than about 4 mm, less than about 3 mm, less than about 2 mm, less than about 1 mm, or less than about or less than about 0.5 mm, e.g., ranging from about 0.5 mm to about 5 mm, including all ranges and subranges therebetween.

The first and second substrates can, in various embodiments be sealed together as disclosed herein, to produce a glass-to-glass weld, a glass-to-ceramic weld, or a glass-to-glass-ceramic weld. In certain embodiments, the seal may be a hermetic seal, e.g., forming one or more air-tight and/or waterproof regions in the device. For example, the sealed device can be hermetically sealed such that it is impervious or substantially impervious to water, moisture, air, and/or other contaminants. By way of non-limiting example, a hermetic seal can be configured to limit the transpiration (diffusion) of oxygen to less than about 10⁻² cm³/m²/day (e.g., less than about 10⁻³/cm³/m²/day), and limit transpiration of water to about 10⁻² g/m²/day (e.g., less than about 10⁻³, 10⁻⁴, 10⁻⁵, or 10⁻⁶ g/m²/day). In various embodiments, a hermetic seal can substantially prevent water, moisture, and/or air from contacting the components protected by the hermetic seal.

In certain embodiments, at least one of the first or second substrates **201a**, **201b** can comprise at least one cavity **211.** As illustrated in **FIG. 5**, the second substrate **201b** comprises a cavity **211**; however substrate **201a** may alternatively or additionally comprise a cavity. While **FIG. 5** depicts a single cavity **211** having a rectangular cross-section, it is to be understood that the cavity can have any given shape or size, as desired for a given application. For example, the cavity can have a square, semi-circular, or semi-elliptical cross-section, or an irregular cross-section, to name a few. It is also possible for the first and/or second substrates to comprise more than one cavity, such as a plurality or an array of cavities. In the case of multiple cavities, the seal can extend around a single cavity, e.g., separating each cavity from the other cavities in the array to create one or more discrete sealed regions or pockets, or the seal can extend around more than one cavity, e.g., a group of two or more cavities, such as three, four, five, ten, or more cavities and so forth. It is also possible for the sealed device to comprise one or more cavities that may not be sealed.

The at least one cavity **211** can have any given depth, which can be chosen as appropriate, e.g., for the type and/or shape and/or amount of the item to be encapsulated in the cavity. By way of non-limiting embodiment, the at least one cavity **211** can extend into the first and/or second substrates to a depth of less than about 1 mm, such as less than about 0.5 mm, less than about 0.4 mm, less than about 0.3 mm, less than about 0.2 mm, less than about 0.1 mm, less than about 0.05 mm, less than about 0.02 mm, or less than about 0.01 mm, including all ranges and subranges therebetween, such as ranging from about 0.01 mm to about 1 mm. It is also envisioned that an array of cavities can be used, each cavity having the same or a different depths, the same or a different shapes, and/or the same or a different sizes, as compared to the other cavities in the array.

As mentioned above, the sealed devices disclosed herein may be used to encapsulate one or more workpieces. Exemplary but non-limiting workpieces may include color-converting elements (such as quantum dots (QDs) and phosphors) and/or light emitting structures (such as laser diodes (LDs), light emitting diodes (LEDs), and organic light emitting diodes (OLEDs)), to name a few. According to some non-limiting embodiments, the sealed device can comprise one or more cavities comprising quantum dots.

Quantum dots can have varying shapes and/or sizes depending on the desired wavelength of emitted light. For example, the frequency of emitted light may increase as the size of the quantum dot decreases, e.g., the color of the emitted light can shift from red to blue as the size of the quantum dot decreases. When irradiated with blue, UV, or near-UV light, a quantum dot may convert the light into longer red, yellow, green, or blue wavelengths. According to various embodiments, the quantum dot can be chosen from red and green quantum dots, emitting in the red and green wavelengths when irradiated with blue, UV, or near-UV light. For instance, the QDs may be irradiated by an LED component emitting blue light (approximately 450-490 nm), UV light (approximately 200-400 nm), or near-UV light (approximately 300-450nm).

Additionally, it is possible that the at least one cavity can comprise the same or different types of quantum dots, e.g., quantum dots emitting different wavelengths. For example, in some embodiments, a cavity can comprise quantum dots emitting both green and red wavelengths, to produce a red-green-blue (RGB) spectrum in the cavity. However, according to other embodiments, it is possible for an individual cavity to comprise only quantum dots emitting the same wavelength, such as a cavity comprising only green quantum dots or a cavity comprising only red quantum dots. For instance, the sealed device can comprise an array of cavities, in which approximately one-third of the cavities may be filled with green quantum dots and approximately one-third of the cavities may be filled with red quantum dots, while approximately one-third of the cavities may remain empty (so as to emit blue light). Using such a configuration, the entire array can produce the RGB spectrum, while also providing dynamic dimming for each individual color.

Of course it is to be understood that cavities containing any type, color, or amount of quantum dots in any ratio are possible and envisioned as falling within the scope of the disclosure. It is within the ability of one skilled in the art to choose the configuration of the cavity or cavities and the types and amounts of quantum dots to place in each cavity to achieve a desired effect. Moreover, although the devices herein are discussed in terms of red and green quantum dots for display devices, it is to be understood that any type of quantum dot can be used, which can emit any wavelength of light including, but not limited to, red, orange, yellow, green, blue, or any other color in the visible spectrum.

Exemplary quantum dots can have various shapes. Examples of the shape of a quantum dot include, but are not limited to, sphere, rod, disk, tetrapod, other shapes, and/or mixtures thereof. Exemplary quantum dots may also be contained in a polymer resin such as, but not limited to, acrylate or another suitable polymer or monomer. Such exemplary resins may also include suitable scattering particles including, but not limited to, TiO₂ or the like.

In certain embodiments, quantum dots comprise inorganic semiconductor material which permits the combination of the soluble nature and processability of polymers with the high efficiency and stability of inorganic semiconductors. Inorganic semiconductor quantum dots are typically more stable in the presence of water vapor and oxygen than their organic semiconductor counterparts. As discussed above, because of their quantum-confined emissive properties, their luminescence can be extremely narrow-band and can yield highly saturated color emission, characterized by a single Gaussian spectrum. Because the nanocrystal diameter controls the quantum dot optical band gap, the fine tuning of absorption and emission wavelength can be achieved through synthesis and structure change.

In certain embodiments, inorganic semiconductor nanocrystal quantum dots comprise Group IV elements, Group II-VI compounds, Group II-V compounds, Group III-VI compounds, Group III-V compounds, Group IV-VI compounds, Group I-III-VI compounds, Group II-IV-VI compounds, or Group II-IV-V compounds, alloys thereof and/or mixtures thereof, including ternary and quaternary alloys and/or mixtures. Examples include, but are not limited to, ZnO, ZnS, ZnSe, ZnTe, CdO, CdS, CdSe, CdTe, HgO, HgS, HgSe, HgTe, AlN, AlP, AlAs, AlSb, GaN, GaP, GaAs, GaSb, GaSe, InN, InP, InAs, InSb, TIN, TIP, TIAs, TISb, PbO, PbS, PbSe, PbTe, alloys thereof, and/or mixtures thereof, including ternary and quaternary alloys and/or mixtures.

In certain embodiments a quantum dot can include a shell over at least a portion of a surface of the quantum dot. This structure is referred to as a core-shell structure. The shell can comprise an inorganic material, more preferably an inorganic semiconductor material, An inorganic shell can passivate surface electronic states to a far greater extent than organic capping groups. Examples of inorganic semiconductor materials for use in a shell include, but are not limited to, Group IV elements, Group II-VI compounds, Group II-V compounds, Group III-VI compounds, Group III-V compounds, Group IV-VI compounds, Group I-III-VI compounds, Group II-IV-VI compounds, or Group II-IV-V compounds, alloys thereof and/or mixtures thereof, including ternary and quaternary alloys and/or mixtures. Examples include, but are not limited to, ZnO, ZnS, ZnSe, ZnTe, CdO, CdS, CdSe, CdTe, HgO, HgS, HgSe, HgTe, AlN, AlP, AlAs, AlSb, GaN, GaP, GaAs, GaSb, GaSe, InN, InP, InAs, InSb, TIN, TIP, TIAs, TISb, PbO, PbS, PbSe, PbTe, alloys thereof, and/or mixtures thereof, including ternary and quaternary alloys and/or mixtures.

In some embodiments, quantum dot materials can include II-VI semiconductors, including CdSe, CdS, and CdTe, and can be made to emit across the entire visible spectrum with narrow size distributions and high emission quantum efficiencies. For example, roughly 2 nm diameter CdSe quantum dots emit in the blue while 8 nm diameter particles emit in the red. Changing the quantum dot composition by substituting other semiconductor materials with a different band gap into the synthesis alters the region of the electromagnetic spectrum in which the quantum dot emission can be tuned. In other embodiments, the quantum dot materials are cadmium-free. Examples of cadmium-free quantum dot materials include InP and InₓGaₓ₋₁P.

In an example of one approach for preparing InₓGaₓ₋₁P, InP can be doped with a small amount of Ga to shift the band gap to higher energies in order to access wavelengths slightly bluer than yellow/green. In an example of another approach for preparing this ternary material, GaP can be doped within to access wavelengths redder than deep blue. InP has a direct bulk band gap of 1.27 eV, which can be tuned beyond 2 eV with Ga doping. Quantum dot materials comprising InP alone can provide tunable emission from yellow/green to deep red; the addition of a small amount of Ga to InP can facilitate tuning the emission down into the deep green/aqua green. Quantum dot materials comprising InₓGaₓ₋₁P (0<x<1) can provide light emission that is tunable over at least a large portion of, if not the entire, visible spectrum. InP/ZnSeS core-shell quantum dots can be tuned from deep red to yellow with efficiencies as high as 70%. For creation of high CRI white QD-LED emitters, InP/ZnSeS can be utilized to address the red to yellow/green portion of the visible spectrum and InₓGaₓ₋₁P will provide deep green to aqua-green emission.

In certain non-limiting embodiments, the sealed devices disclosed herein can comprise one or more regions of high transmission and one or more regions of high reflectance. For instance, a reflecting region may correspond to the seal **207** area, which can be tuned to a desired level of reflectance by the thickness and/or types of metal(s) in the sealing layer, as well as the number, type, and/or melting point of the chosen films in the case of two or more metal and/or glass films. Similarly, a transmissive region can correspond to unsealed portions of the sealed device, e.g., the portions of transparent glass around which a seal can extend. Of course, the seal **207** can also be tuned to have low reflectance and/or high transparency if desired. By way of a non-limiting example, sealed devices comprising reflective and transmissive regions may be desirable for encapsulating color-converting elements, such as QDs. Such packages can have improved QD emissions, as the light output from the package can be better directed through the transmissive regions and directed away from the reflective regions, as desired.

It will be appreciated that the various disclosed embodiments may involve particular features, elements or steps that are described in connection with that particular embodiment. It will also be appreciated that a particular feature, element or step, although described in relation to one particular embodiment, may be interchanged or combined with alternate embodiments in various non-illustrated combinations or permutations.

It is also to be understood that, as used herein the terms "the," "a," or "an," mean "at least one," and should not be limited to "only one" unless explicitly indicated to the contrary. Thus, for example, reference to "at least one seal" includes examples having two or more such seals unless the context clearly indicates otherwise. Similarly, a "plurality" or an "array" is intended to denote two or more, such that an "array of cavities" or a "plurality of cavities" denotes two or more such cavities.

Ranges can be expressed herein as from "about" one particular value, and/or to "about" another particular value. When such a range is expressed, examples include from the one particular value and/or to the other particular value. Similarly, when values are expressed as approximations, by use of the antecedent "about," it will be understood that the particular value forms another aspect. It will be further understood that the endpoints of each of the ranges are significant both in relation to the other endpoint, and independently of the other endpoint.

The terms "substantial," "substantially," and variations thereof as used herein are intended to note that a described feature is equal or approximately equal to a value or description. For example, a "substantially planar" surface is intended to denote a surface that is planar or approximately planar. Moreover, "substantially similar" is intended to denote that two values are equal or approximately equal.

Unless otherwise expressly stated, it is in no way intended that any method set forth herein be construed as requiring that its steps be performed in a specific order. Accordingly, where a method claim does not actually recite an order to be followed by its steps or it is not otherwise specifically stated in the claims or descriptions that the steps are to be limited to a specific order, it is no way intended that any particular order be inferred.

While various features, elements or steps of particular embodiments may be disclosed using the transitional phrase "comprising," it is to be understood that alternative embodiments, including those that may be described using the transitional phrases "consisting" or "consisting essentially of," are implied. Thus, for example, implied alternative embodiments to a device that comprises A+B+C include embodiments where a device consists of A+B+C and embodiments where a device consists essentially of A+B+C.

The invention is defined by the appended claims.

## Claims

1. A sealed device (200) comprising:
a first glass substrate (201a) comprising a first surface, a second substrate (201b) comprising a second surface, and at least one seal (207) formed therebetween, wherein the at least one seal (207) comprises metal nanoparticles having an average particle size of less than 50 nm;
wherein the metal nanoparticles are incorporated into at least one of the first surface and the second surface; and
**characterized in that** a melting point of the metal forming the metal nanoparticles is within a range from 50% to 100% of a glass transition temperature of the first and/or second substrates (201a, 201b).

2. The sealed device (200) of claim 1, wherein the second substrate (201b) is chosen from glass, glass-ceramic, and ceramic substrates.

3. The sealed device (200) of any of claims 1 to 2, wherein the at least one seal (207) is transparent at visible wavelengths.

4. The sealed device (200) of any of claims 1 to 3, wherein the metal nanoparticles have an average particle size of less than 10 nm and nanoparticles are chosen from aluminum, titanium, iron, chromium, silver, gold, copper, zinc, magnesium, nickel, molybdenum, and combinations thereof.

5. The sealed device (200) of any of claims 1 to 4, wherein the at least one seal (207) has a thickness ranging from 100 nm to 500 microns and wherein the at least one seal (207) comprises from 1 000 to 100 000 metal nanoparticles per µm³.

6. The sealed device (200) of any of claims 1 to 5, wherein at least one of the first or second substrates (201a, 201b) comprises at least one cavity (211) and wherein the at least one cavity (211) contains at least one component chosen from quantum dots, laser diodes, light emitting diodes, and organic light emitting diodes.

7. A display device comprising the sealed device (200) of any of claims 1 to 6.

8. A method for making a sealed device (200), the method comprising:
positioning a sealing layer (103) comprising at least one metal between a first glass substrate (101a) comprising a first surface and a second substrate (101b) comprising a second surface to form a sealing interface (105); and
directing a laser beam operating at a predetermined wavelength onto the sealing interface (105) to form at least one seal (207) between the first and second substrates (101a, 101b) and to convert the at least one metal to metal nanoparticles having an average particle size of less than 50 nm;
wherein the metal nanoparticles are incorporated into at least one of the first surface and the second surface; and
**characterized in that** a melting point of the metal forming the metal nanoparticles is within a range from 50% to 100% of a glass transition temperature of the first and/or second substrates (201a, 201b).

9. The method of claim 8, wherein the second substrate (101b) is chosen from glass, glass-ceramic, and ceramic substrates.

10. The method of any of claims 8 to 9, wherein the metal nanoparticles have an average particle size of less than 10 nm and nanoparticles are chosen from aluminum, titanium, iron, chromium, silver, gold, copper, zinc, magnesium, nickel, molybdenum, and combinations thereof.

11. The method of any of claims 8 to 10, wherein the sealing layer (103) comprises at least one metal film and at least one glass sealing film.

12. The method of any of claims 8 to 11, wherein the sealing layer (103) absorbs light at the predetermined wavelength and heats the sealing interface (105) to a sealing temperature.

13. The method of any of claims 8 to 12, wherein the sealing layer (103) has an absorption of greater than 10% at the predetermined wavelength.

14. The method of any of claims 8 to 13, wherein the sealing layer (103) has a thickness of less than 500 nm.

## Patentansprüche

1. Abgedichtete Vorrichtung (200), umfassend:
ein erstes Glassubstrat (201a), das eine erste Oberfläche umfasst, ein zweites Substrat (201b), das eine zweite Oberfläche umfasst, und mindestens eine Dichtung (207), die dazwischen ausgebildet ist, wobei die mindestens eine Dichtung (207) Metallnanopartikel mit einer durchschnittlichen Partikelgröße von weniger als 50 nm umfasst,
wobei die Metallnanopartikel in mindestens eine von der ersten Oberfläche und der zweiten Oberfläche eingelagert sind; und
**dadurch gekennzeichnet, dass** ein Schmelzpunkt des Metalls, das die Metallnanopartikel ausbildet, in einem Bereich von 50% bis 100 % einer Glasübergangstemperatur des ersten und/oder des zweiten Substrats (201a, 201b) liegt.

2. Abgedichtete Vorrichtung (200) nach Anspruch 1, wobei das zweite Substrat (201b) aus Glas-, Glaskeramik- und Keramiksubstraten ausgewählt ist.

3. Abgedichtete Vorrichtung (200) nach einem der Ansprüche 1 bis 2, wobei die mindestens eine Dichtung (207) bei sichtbaren Wellenlängen transparent ist.

4. Abgedichtete Vorrichtung (200) nach einem der Ansprüche 1 bis 3, wobei die Metallnanopartikel eine durchschnittliche Partikelgröße von weniger als 10 nm aufweisen und Nanopartikel aus Aluminium, Titan, Eisen, Chrom, Silber, Gold, Kupfer, Zink, Magnesium, Nickel, Molybdän und Kombinationen davon ausgewählt sind.

5. Abgedichtete Vorrichtung (200) nach einem der Ansprüche 1 bis 4, wobei die mindestens eine Dichtung (207) eine Dicke im Bereich von 100 nm bis 500 Mikron aufweist und wobei die mindestens eine Dichtung (207) 1.000 bis 100.000 Metall-Nanopartikel pro µm³ umfasst.

6. Abgedichtete Vorrichtung (200) nach einem der Ansprüche 1 bis 5, wobei mindestens eines von dem ersten oder dem zweiten Substrat (201a, 201b) mindestens einen Hohlraum (211) umfasst und wobei der mindestens eine Hohlraum (211) mindestens eine Komponente enthält, die aus Quantenpunkten, Laserdioden, lichtemittierenden Dioden und organischen lichtemittierenden Dioden ausgewählt ist.

7. Anzeigevorrichtung, umfassend die abgedichtete Vorrichtung (200) nach einem der Ansprüche 1 bis 6.

8. Verfahren zum Herstellen einer abgedichteten Vorrichtung (200), wobei das Verfahren umfasst:
Positionieren einer Abdichtungsschicht (103), die mindestens ein Metall umfasst, zwischen einem ersten Glassubstrat (101a), das eine erste Oberfläche umfasst, und einem zweiten Substrat (101b), das eine zweite Oberfläche umfasst, um eine Abdichtungsgrenzfläche (105) auszubilden; und
Richten eines Laserstrahls, der mit einer vorbestimmten Wellenlänge arbeitet, auf die Abdichtungsgrenzfläche (105), um mindestens eine Dichtung (207) zwischen dem ersten und dem zweiten Substrat (101a, 101b) auszubilden und das mindestens eine Metall in Metallnanopartikel mit einer durchschnittlichen Partikelgröße von weniger als 50 nm umzuwandeln;
wobei die Metallnanopartikel in mindestens eine von der ersten Oberfläche und der zweiten Oberfläche eingelagert sind; und
**dadurch gekennzeichnet, dass** ein Schmelzpunkt des Metalls, das die Metallnanopartikel ausbildet, in einem Bereich von 50% bis 100 % einer Glasübergangstemperatur des ersten und/oder des zweiten Substrats (201a, 201b) liegt.

9. Verfahren nach Anspruch 8, wobei das zweite Substrat (101b) aus Glas-, Glaskeramik- und Keramiksubstraten ausgewählt ist.

10. Verfahren nach einem der Ansprüche 8 bis 9, wobei die Metallnanopartikel eine durchschnittliche Partikelgröße von weniger als 10 nm aufweisen und Nanopartikel aus Aluminium, Titan, Eisen, Chrom, Silber, Gold, Kupfer, Zink, Magnesium, Nickel, Molybdän und Kombinationen davon ausgewählt sind.

11. Verfahren nach einem der Ansprüche 8 bis 10, wobei die Abdichtungsschicht (103) mindestens einen Metallfilm und mindestens einen Glasabdichtungsfilm umfasst.

12. Verfahren nach einem der Ansprüche 8 bis 11, wobei die Abdichtungsschicht (103) Licht bei der vorbestimmten Wellenlänge absorbiert und die Abdichtungsgrenzfläche (105) auf eine Abdichtungstemperatur erwärmt.

13. Verfahren nach einem der Ansprüche 8 bis 12, wobei die Abdichtungsschicht (103) eine Absorption von mehr als 10 % bei der vorbestimmten Wellenlänge aufweist.

14. Verfahren nach einem der Ansprüche 8 bis 13, wobei die Abdichtungsschicht (103) eine Dicke von weniger als 500 nm aufweist.

## Revendications

1. Dispositif étanche (200) comprenant :
un premier substrat de verre (201a) comprenant une première surface, un second substrat (201b) comprenant une seconde surface, et au moins un joint d'étanchéité (207) formé entre eux, ledit au moins un joint d'étanchéité (207) comprenant des nanoparticules métalliques comportant une taille de particule moyenne inférieure à 50 nm ;
lesdites nanoparticules métalliques étant incorporées dans au moins l'une de la première surface et de la seconde surface ; et
**caractérisé en ce qu'**un point de fusion du métal formant les nanoparticules métalliques est compris dans une plage allant de 50 % à 100 % d'une température de transition vitreuse des premier et/ou second substrats (201a, 201b).

2. Dispositif étanche (200) selon la revendication 1, ledit second substrat (201b) étant choisi parmi les substrats en verre, en vitrocéramique et en céramique.

3. Dispositif étanche (200) selon l'une quelconque des revendications 1 à 2, ledit au moins un joint d'étanchéité (207) étant transparent aux longueurs d'onde visibles.

4. Dispositif étanche (200) selon l'une quelconque des revendications 1 à 3, lesdites nanoparticules métalliques comportant une taille de particule moyenne inférieure à 10 nm et lesdites nanoparticules étant choisies parmi l'aluminium, le titane, le fer, le chrome, l'argent, l'or, le cuivre, le zinc, le magnésium, le nickel, le molybdène et des combinaisons de ceux-ci.

5. Dispositif étanche (200) selon l'une quelconque des revendications 1 à 4, ledit au moins un joint d'étanchéité (207) comportant une épaisseur allant de 100 nm à 500 microns et ledit au moins un joint d'étanchéité (207) comprenant de 1 000 à 100 000 nanoparticules métalliques par µm³.

6. Dispositif étanche (200) selon l'une quelconque des revendications 1 à 5, au moins l'un des premier ou second substrats (201a, 201b) comprenant au moins une cavité (211) et ladite au moins une cavité (211) contenant au moins un composant choisi parmi les points quantiques, les diodes laser, les diodes électroluminescentes et les diodes électroluminescentes organiques.

7. Dispositif d'affichage comprenant le dispositif étanche (200) selon l'une quelconque des revendications 1 à 6.

8. Procédé permettant la fabrication d'un dispositif étanche (200), le procédé comprenant :
le positionnement d'une couche d'étanchéité (103) comprenant au moins un métal entre un premier substrat de verre (101a) comprenant une première surface et un second substrat (101b) comprenant une seconde surface pour former une interface d'étanchéité (105) ; et
l'orientation d'un faisceau laser fonctionnant à une longueur d'onde prédéfinie sur l'interface d'étanchéité (105) pour former au moins un joint d'étanchéité (207) entre les premier et second substrats (101a, 101b) et pour convertir la au moins une nanoparticule métal à métal comportant une taille de particule moyenne inférieure à 50 nm ;
lesdites nanoparticules métalliques étant incorporées dans au moins l'une de la première surface et de la seconde surface ; et
**caractérisé en ce qu'**un point de fusion du métal formant les nanoparticules métalliques est compris dans une plage allant de 50 % à 100 % d'une température de transition vitreuse des premier et/ou second substrats (201a, 201b).

9. Procédé selon la revendication 8, ledit second substrat (101b) étant choisi parmi les substrats en verre, en vitrocéramique et en céramique.

10. Procédé selon l'une quelconque des revendications 8 à 9, lesdites nanoparticules métalliques comportant une taille de particule moyenne inférieure à 10 nm et lesdites nanoparticules étant choisies parmi l'aluminium, le titane, le fer, le chrome, l'argent, l'or, le cuivre, le zinc, le magnésium, le nickel, le molybdène, et des combinaisons de ceux-ci.

11. Procédé selon l'une quelconque des revendications 8 à 10, ladite couche d'étanchéité (103) comprenant au moins un film métallique et au moins un film d'étanchéité en verre.

12. Procédé selon l'une quelconque des revendications 8 à 11, ladite couche d'étanchéité (103) absorbant la lumière à la longueur d'onde prédéfinie et chauffant l'interface d'étanchéité (105) à une température d'étanchéité.

13. Procédé selon l'une quelconque des revendications 8 à 12, ladite couche d'étanchéité (103) comportant une absorption supérieure à 10 % à la longueur d'onde prédéfinie.

14. Procédé selon l'une quelconque des revendications 8 à 13, ladite couche d'étanchéité (103) comportant une épaisseur inférieure à 500 nm.
